# EUROPEAN PATENT APPLICATION

(11) **EP 2 221 553 A2**
(43) Date of publication of application: **25.08.2010**
(21) Application number: 10153669.6
(22) Date of filing: 16.02.2010
(51) Int. Cl.: F24J 2/06, F24J 2/14, F24J 2/54

(54) **Two-part Solar Energy Collection System with Replaceable Solar Collector Component**

(30) Priority: 18.02.2009 US 388500; 27.05.2009 US 473240; 03.11.2009 US 611873
(71) Applicant: Palo Alto Research Center Incorporated, Palo Alto, California 94304 (US)
(72) Inventor: Littau, Karl A, Palo Alto, CA 94306 (US); Maeda, Patrick Y, Mountain View, CA 94040 (US); Cheung, Patrick C, Castro Valley, CA 94552 (US); Parekh, Nitin, Los Altos, CA 94024 (US)
(74) Representative: Skone James, Robert Edmund

(57) **Abstract**

A two-part solar energy collection system (100) for installation on a planar support surface (e.g., a rooftop) includes a permanent positioning component (110) including a base structure (120) and a replaceable solar collector component (150) including solar energy collection elements (160) fixedly mounted on a support frame (170). Each collection element (160) includes an optical element (161) arranged to focus solar radiation onto a focal line (FL), and a linearly-arranged solar energy collector (165) (e.g., PV cells) fixedly maintained on the focal line. The replaceable solar collector component (150) is secured to a rotating platform (125) of the base structure such that the focal lines of the solar energy collection elements are maintained in a plane that is substantially parallel to the support surface, and the rotating platform and replaceable solar collector component are collectively pivoted by a positioning system around a rotational axis to align the PV cells) parallel to the received sunlight beams.

## Description

The present invention relates generally to an improvement in solar-electricity generation, and more particularly to a two-part solar power generation system that is suitable for either residential rooftop-mounted applications or commercial applications including utility scale installations.

The need for "green" sources of electricity (i.e., electricity not produced by petroleum-based products) has given rise to many advances in solar-electricity generation for both commercial and residential applications.

Solar-electricity generation typically involves the use of photovoltaic (PV) elements (solar cells) that convert sunlight directly into electricity. These solar cells are typically made using square or quasi-square silicon wafers that are doped using established semiconductor fabrication techniques and absorb light irradiation (e.g., sunlight) in a way that creates free electrons, which in turn are caused to flow in the presence of a built-in field to create direct current (DC) power. The DC power generated by an array including several solar cells is collected on a grid placed on the cells.

Solar-electricity generation is currently performed in both residential and commercial settings. In a typical residential application, a relatively small array of solar cells is mounted on a house's rooftop, and the generated electricity is typically supplied only to that house. In commercial applications, larger arrays are disposed in sunlit, otherwise unused regions (e.g., deserts), and the resulting large amounts of power are conveyed to businesses and houses over power lines. The benefit of mounting solar arrays on residential houses or commercial installation close to the load is that the localized generation of power reduces losses associated with transmission over long power lines, and requires fewer resources (i.e., land, power lines and towers, transformers, etc.) to distribute the generated electricity in comparison to commercially-generated solar-electricity far from useful loads such as in some utility scale solar installations. However, as set forth below, current solar-electricity generation devices are typically not economically feasible in residential settings.

Photovoltaic solar-electricity generation devices can generally be divided in to two groups: flat panel solar arrays and concentrating-type solar devices. Flat panel solar arrays include solar cells that are arranged on large, flat panels and subjected to unfocused direct and diffuse sunlight, whereby the amount of sunlight converted to electricity is directly proportional to the area of the solar cells. In contrast, concentrating-type photovoltaic solar devices utilize an optical element that focuses (concentrates) mostly direct sunlight onto a relatively small solar cell located at the focal point (or line) of the optical element.

Flat panel solar arrays have both advantages and disadvantages over concentrating-type solar devices. An advantage of flat panel solar arrays is that their weight-to-size ratio is relatively low, facilitating their use in residential applications because they can be mounted on the rooftops of most houses without significant modification to the roof support structure. In addition, they accept sun from large angles facilitating relatively straightforward fixed mounting on rooftops and other flat installation sites. However, flat panel solar arrays have relatively low efficiencies (i.e., approximately 15%), which requires large areas to be covered in order to provide sufficient amounts of electricity to make their use worthwhile. Thus, due to the high cost of silicon, current rooftop flat panel solar arrays cost over $5 per Watt, so it can take 25 years for a home owner to recoup the investment by the savings on his/her electricity bill. Economically, flat panel solar arrays are not a viable investment for a typical homeowner without subsidies.

By providing an optical element that focuses (concentrates) sunlight onto a solar cell, concentrating-type solar arrays avoid the high silicon costs of flat panel solar arrays, and may also exhibit higher efficiency through the use of smaller, higher efficiency solar cells. The amount of concentration varies depending on the type of optical device, and ranges from 10X to 100X for trough reflector type devices (described in additional detail below) to as high as 600X to 10,000X using some cassegrain-type solar devices. However, a problem with concentrating-type solar devices in general is that the acceptance angle of the systems is limited thus the orientation of the optical element must be continuously adjusted using a two degree of freedom tracking system throughout the day in order to maintain peak efficiency, which requires a substantial foundation and motor to support and position the optical element, and this structure must also be engineered to withstand wind and storm forces. Moreover, higher efficiency (e.g., cassegrain-type) solar devices require even higher engineering demands on reflector material, reflector geometry, and tracking accuracy. Due to the engineering constraints imposed by the support/tracking system, concentrating-type solar devices are rarely used in residential or commercial rooftop settings because the rooftop of most houses and buildings would require substantial retrofitting to support their substantial weight and wind loading structures. Instead, concentrating-type solar devices are typically limited to commercial settings in which cement or metal foundations are disposed on the ground. In addition for all installations the cost of such two degree of freedom tracking systems with associated wind loading and other structural support can increase the cost of the concentrator and thus offset the cost reductions achieved through the reduction of silicon PV elements used.

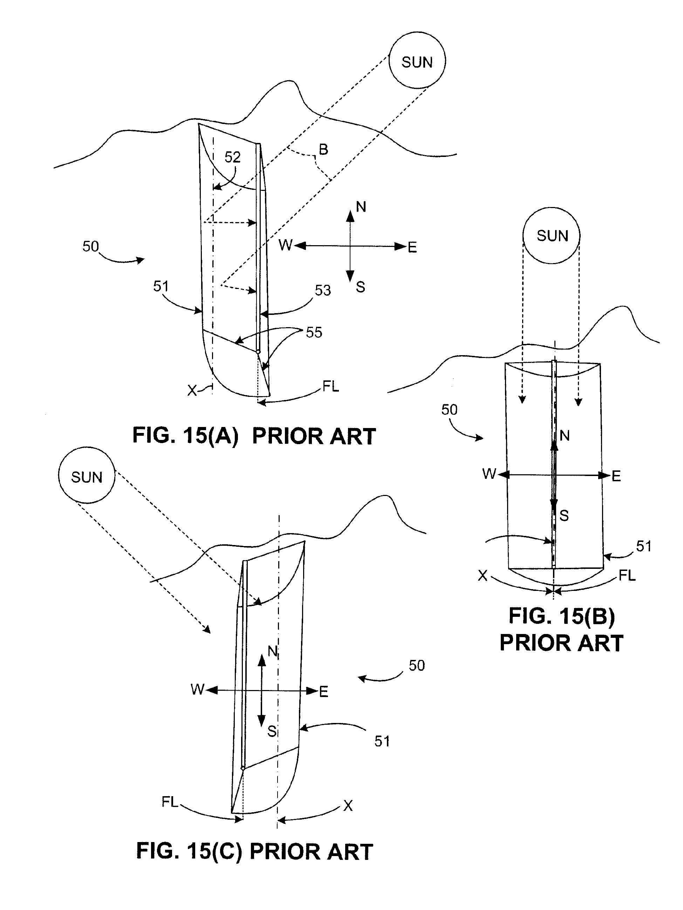

Figs. 15(A) to 15(C) are simplified perspective views showing a conventional trough reflector solar-electricity generation device 50, which represents one type of conventional concentrating-type solar device. Device 50 generally includes a trough reflector 51, having a mirrored (reflective) surface 52 shaped to reflect solar (light) beams B onto a focal line FL, an elongated photoreceptor 53 mounted in fixed relation to trough reflector 51 along focal line FL by way of support arms 55, and a tracking system (not shown) for supporting and rotating trough reflector 51 around a horizontal axis X that is parallel to focal line FL. In conventional settings, trough reflector 51 is positioned with axis X aligned in a north-south direction, and as indicated in Figs. 15(A) to 15(C), the tracking system rotates trough reflector 51 in an east-to-west direction during the course of the day such that beams B are directed onto mirror surface 52. As mentioned above, a problem with this arrangement in a residential setting is that the tracking system (i.e., the support structure and motor needed to rotate trough reflector 51) requires significant modifications to an average residential house rooftop. On the other hand, if the troughs are made small and are packed together side by side, and multiple troughs driven from one motor, then there is an engineering difficulty to keep the multiple hinges and linkages to pivot together to precisely focus sunlight.

What is needed is an economically viable residential or commercial rooftop-mounted or ground mounted solar-electricity generation system that overcomes the problems associated with conventional solar-electricity generation systems set forth above. In particular, what is needed is a solar-electricity generation device that utilizes less PV material than conventional flat panel solar arrays, avoids the heavy, expensive tracking systems of conventional concentrating-type solar devices, and is inexpensive to install and maintain

The present invention is directed to a two-part solar-energy collection (e.g., a solar-electricity generation) system that includes a permanent (i.e., non-replaceable) positioning component and a low-cost, replaceable solar collector component. The positioning component includes a base structure having frame that facilitates permanent connection to a support surface (e.g., the rooftop of a residential house), a turntable-like rotating platform mounted on the frame for detachably supporting the solar collector assembly, and a rotational positioning (motion/tracking) system for adjusting the rotational angle of the rotating platform around a rotational axis that is perpendicular to the underlying support surface. The positioning system is constructed using a group of robust elements designed to be permanently attached to the support surface (e.g., rooftop) for the life of the solar-energy collection system. In contrast, the solar collector assembly includes one or more solar energy collection elements that are mounted on a flat support frame using low-cost fabrication techniques. The planar (flat) support frame is detachably mounted to the rotating platform of the positioning system, whereby the weight of the solar energy collection elements is spread by the flat support structure over a large area, and the low-profile of the assembled system avoids unnecessary wind forces. By combining the robust, permanent positioning component with the low-cost, replaceable solar collector assembly, the present invention provides an economically viable solar-power generation system because the components that are inclined to wear out over a relatively short amount of time (e.g., photovoltaic cells) are disposed on the low-cost solar collector assembly, which can be easily replaced periodically to maximize power generation efficiency.

According to an embodiment of the present invention, the one or more solar energy collection elements are implemented by trough reflectors that are rotated by the rotational positioning system around the rotational axis that is non-parallel (e.g., perpendicular) to the focal line defined by the trough reflector (i.e., not horizontal as in conventional trough reflector systems). In addition, the rotational positioning system includes a tracking system that controls a motor coupled to the rotating platform in order to adjust the angular position of the solar energy collection elements such that the focal line defined by the trough reflector is aligned generally parallel to incident solar beams (e.g., aligned in a generally east-west direction at sunrise, not north/south as in conventional trough reflector systems). By rotating the trough reflector around an axis that is perpendicular to the focal line of the trough reflector, the trough reflector remains in-plane with or in a fixed, canted position relative to an underlying support surface (e.g., the rooftop of a residential house), thereby greatly reducing the engineering demands on the strength of the support structure and the amount of power required to operate the tracking system, avoiding the problems associated with adapting commercial trough reflector devices, and providing an economically viable solar-electricity generation device that facilitates residential rooftop and other implementation.

According to another embodiment of the present invention, the one or more solar energy collection elements are implemented by trough reflectors that include a solid transparent (e.g., glass or clear plastic) optical element having a predominately flat upper aperture surface and a convex lower surface, a linear solar energy collection element (e.g., a string of photovoltaic cells) mounted on the upper aperture surface, and a curved reflective mirror that is deposited on or otherwise conforms to the convex lower surface. The convex lower surface and the curved reflective mirror have a linear parabolic shape and are arranged such that sunlight passing through the flat upper aperture surface is reflected and focused by the mirror (whose reflective surface faces into the optical element) onto a focal line that coincides with a linear region of the upper aperture surface upon which the linear solar energy collection element is mounted. The use of the optical element provides several advantages over conventional trough reflector arrangements. First, by producing the optical element using a material having an index of refraction in the range of 1.05 and 2.09 (and more preferably in the range of 1.15 to 1.5), the optical element reduces deleterious end effects by causing the refracted light to transit the optical element more normal to the array, thus reducing the amount of poorly or non-illuminated regions at the ends of the linear solar energy collection element. Second, because the optical element is solid (i.e., because the aperture and convex mirror surfaces remain fixed relative to each other), the mirror and solar energy collection element remain permanently aligned, thus maintaining optimal optical operation while minimizing maintenance costs. A third advantage is the ability to reduce the normal operating cell temperature (NOCT) of photovoltaic-based (PV-based) solar energy collection element. Moreover, because the mirror conforms to the convex surface, the loss of light at gas/solid interfaces is minimized because only solid optical element material (e.g., plastic or low-iron glass) is positioned between the aperture surface and convex surface/mirror, and between the convex surface/mirror and the solar energy collection element. This arrangement also minimizes maintenance because the active surface of the solar energy collection element and the mirror surface are permanently protected from dirt and corrosion by the solid optical element material, leaving only the relatively easy to clean flat upper aperture surface exposed to dirt and weather. In accordance with a specific embodiment of the invention, the mirror is a metal film that is directly formed (e.g., sputter deposited or plated) onto the convex surface of the optical element. By carefully molding the optical element to include convex and aperture surfaces having the desired shape and position, the mirror is essentially self-forming and self-aligned when formed as a mirror material film, thus greatly simplifying the manufacturing process and minimizing production costs. Alternately, the mirror includes a reflective film that is adhesively or otherwise mounted to the back of the reflector, which provides self-aligned and self-forming advantages that are similar to that of directly formed mirrors, and includes even further reduced cost at the expense of slightly lower reflectivity.

According to a specific embodiment of the present invention, the replaceable solar collector component includes multiple solar energy collection elements that are fixedly mounted on a support frame, where each solar energy collection elements includes an associated optical element arranged to focus solar radiation onto an associated focal line, and an associated linearly-arranged solar energy collector fixedly maintained on the associated focal line. According to an aspect of the invention, the solar energy collectors are fixedly arranged on the support frame such that the associated focal lines are parallel and define a single plane, thereby facilitating optimal alignment of all of the linearly-arranged solar energy collectors to the incident sunlight as a group. The multiple solar energy collectors (e.g., linearly connected PV cells) mounted onto each optical element are connected in series using known techniques to provide maximum power generation. The low profile and in-plane rotation of the solar energy collection elements reduce the chance of wind and storm damage in comparison to conventional trough reflector arrangements. In accordance with an embodiment, multiple equal-length solar energy collection elements are mounted on a square or rectangular support frame, thereby providing an arrangement in which the PV receivers, which are typically constructed of PV cells strung together in series with the number of cells in the string proportional to the string length, of all of the trough reflectors generate electricity having a similar voltage, and in which individual trough reflectors are conveniently replaceable. In yet another alternative embodiment, multiple solar energy collection elements are combined to form square standardized units that are then mounted on the support frame, thereby facilitating the formation of replaceable solar collector component having a variety of sizes (i.e., differing numbers of standardized units). An optional centrally located main conduit is provided to connect the standardized units to a power transfer system provided on the positioning system, or directly to an external load.

These and other features, aspects and advantages of the present invention will become better understood with regard to the following description, appended claims, and accompanying drawings, where:

Figs. 1(A) and 1(B) are exploded perspective and top side perspective views showing a simplified solar-electricity collection system according to a generalized embodiment of the present invention;

Figs. 2(A) and 2(B) are simplified cross-sectional end and side views showing a solar energy collection elementof the system of Fig. 1 during operation;

Fig. 3 is a perspective top view showing a simplified representation of the system of Fig. 1 disposed on the rooftop of a residential house;

Figs. 4(A), 4(B) and 4(C) are simplified perspective views showing a method for positioning the trough reflector-type solar energy collection element of Fig. 1 during operation according to an embodiment of the present invention;

Fig. 5 is an exploded perspective view showing a solar energy collection element according to an alternative embodiment of the present invention;

Fig. 6 is a top side perspective view showing a solar-electricity collection system including the solar energy collection element of Fig. 5 according to another embodiment of the present invention;

Fig. 7 is an exploded top side perspective view showing a solar-electricity collection system according to another specific embodiment of the present invention;

Figs. 8(A), 8(B) and 8(C) are simplified top views showing the system of Fig. 7 during operation;

Fig. 9 a simplified perspective view showing a solar-electricity collection system according to another embodiment of the present invention;

Fig. 10 a simplified exploded perspective view showing a simplified removable solar collecting component including sub-assembly units for a solar-electricity collection system according to another embodiment of the present invention;

Fig. 11 is a simplified top plan view including a wiring diagram for a main conduit of the removable solar collecting component of Fig. 10;

Fig. 12 is an exploded perspective view showing a solar-electricity collection system including the removable solar collecting component of Fig. 10;

Figs. 13(A) and 13(B) are simplified perspective views showing alternative support structures for constructing an sub-assembly unit according to an alternative embodiment of the present invention;

Figs. 14(A) and 14(B) are simplified partial end and top perspective views showing a sub-assembly unit including heat sink structures according to an alternative embodiment of the present invention; and

Figs. 15(A), 15(B) and 15(C) are simplified perspective views showing a conventional trough reflector solar-electricity generation device during operation.

The present invention relates to an improvement in solar-energy collection systems. The following description is presented to enable one of ordinary skill in the art to make and use the invention as provided in the context of a particular application and its requirements. As used herein, directional terms such as "upper", "lower", "vertical" and "horizontal" are intended to provide relative positions for purposes of description, and are not intended to designate an absolute frame of reference. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

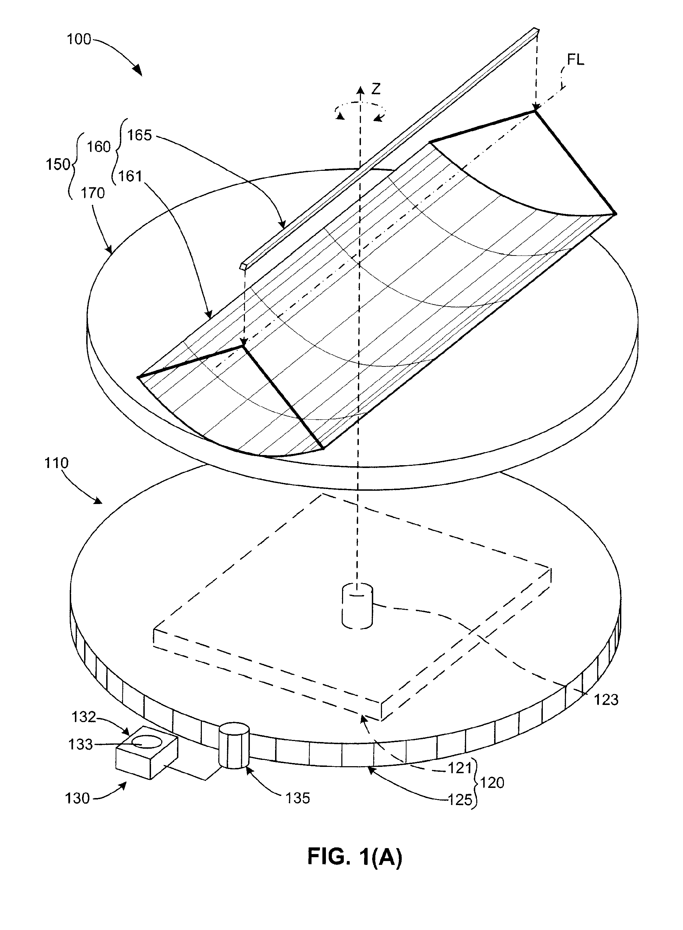

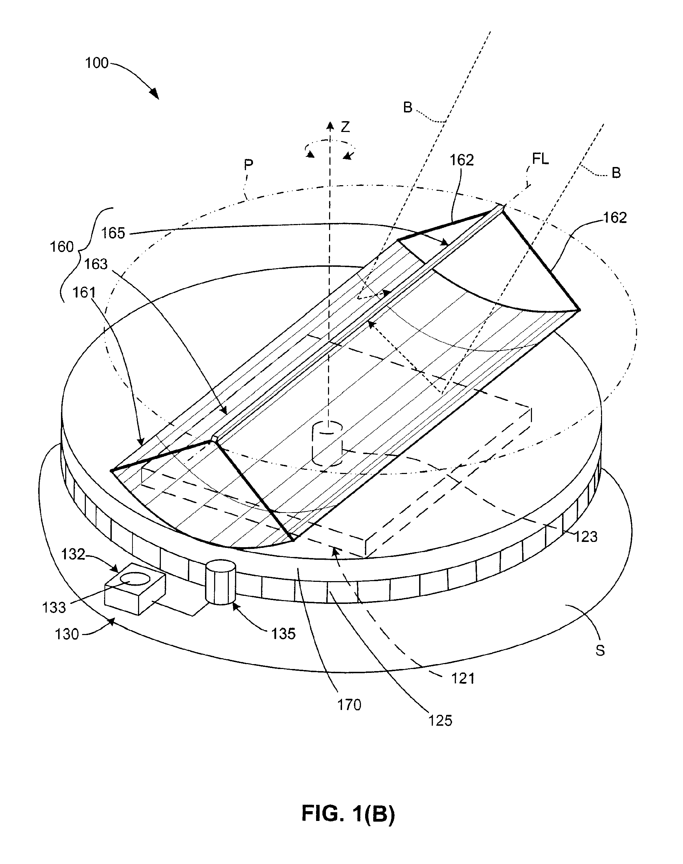

Figs. 1(A) and 1(B) are exploded and assembled perspective views, respectively, showing a two-part solar energy collection system 100 according to a simplified exemplary embodiment of the present invention. Two-part solar energy collection system 100 is designed for installation on a planar support surface (e.g., the rooftop of a residential house), and generally includes a permanent positioning component 110 and a low-cost, replaceable solar collector component 150. Positioning component 110 functions to provide a permanent (i.e., non-replaceable) fixture that supports and positions replaceable solar collector component 150 in the manner described below. Those skilled in the art recognize that the support and positioning functions performed by positioning component 110 involve components that are typically not subject to the extreme thermal conditions under which solar collector elements (e.g., photovoltaic cells) are subjected. Therefore, positioning component 110 is constructed using a group of robust hardware elements designed to remain attached to the installation site (e.g., a rooftop) for the life of the unit. In contrast, solar collector component 150 includes solar collection elements that typically wear out (fail) in a relatively short amount of time due to extreme thermal cycling, solar exposure, and other environmental forces, and therefore must be replaced frequently to maximize power generation. Therefore, solar collector component 150 functions as a replaceable unit including one or more solar collection elements assembled in a manner that is strong enough to be handled easily during assembly, transport, and installation, but utilizes construction techniques that are optimized to its shorter life cycle. In one series of embodiments, solar collector component 150 includes a single-piece structure in which solar collection elements are permanently affixed to a support frame using low-cost fabrication techniques (e.g., using plastic lamination or other low-cost assembly methods). With this approach, an entirely new solar collector component 150 is needed to replace a worn out solar collector component 150. Alternatively, solar collector component 150 includes an assembly in which solar collection elements are attached to a relatively rugged support frame using removable fasteners that facilitate easy replacement of worn-out solar collection elements, thereby reducing waste by enabling the re-use of the rugged support frame. By combining the robust, permanent positioning component 110 with low-cost, replaceable solar collector assembly 150, the present invention provides an economically viable residential rooftop-mounted solar-power generation system because the components that are inclined to wear out over a relatively short amount of time (e.g., concentrator elements and photovoltaic cells) are disposed on low-cost solar collector assembly 150, which can be easily replaced periodically to maximize power generation efficiency.

Referring to the lower portion of Fig. 1(A), non-replaceable positioning component 110 includes a base structure 120 and a rotational positioning system 130 that is operably connected to the base structure 120 in the manner described below.

Base structure 120 functions as a "turntable" structure for supporting replaceable solar collector assembly 150. In the generalized embodiment shown in Fig. 1(A), base structure 120 includes a frame 121 that facilitates permanent connection to a support surface (e.g., a rooftop surface), and a turntable-like rotating platform 125 rotatably disposed on frame 121, e.g., by way of a centrally located rotatable bearing 123. According to an aspect of the invention discussed in additional detail below, rotating platform 125 is rotatably connected to frame 121 by way of rotatable bearing 123 to rotate around a rotational axis Z that is aligned in a vertical direction that is substantially perpendicular to the underlying support surface (e.g., support surface S shown in Fig. 1(B)). Base structure 120 is constructed using robust hardware elements (e.g., mounting hardware and wind loading hardware that are integrally formed on or attached to frame 121, roller or ball bearings, an optional protective housing and other hardware elements, not shown) that are designed to remain in one position (e.g., attached to a rooftop) for the life of the unit. In addition, rotating platform 125 is provided with suitable hardware such as aluminum braces and fastening points designed to support and securely connect replaceable solar collector assembly 150.

Rotational positioning system 130 functions to adjust the rotational angle of rotating platform around 125 relative to base 121 around rotational axis Z. In the generalized embodiment shown in Fig. 1(A), positioning system 130 performs this function using a tracking system 132 including a sensor 133, a motor 135 that operably engages a peripheral edge of rotating platform 125, and associated control electronics that actuate motor 135 according to a sun position detected by sensor 133. Additional elements (e.g., electrical cabling from the unit to any inverter or power conditioning or routing elements, or the inverter or power conditioning or routing elements themselves) may also be included in rotational positioning system 130. Similar to base structure 120, positioning system 130 is constructed using robust hardware elements. By placing tracking motor 135 such that it contacts the peripheral edge of rotating platform 125, which controls the rotational position of solar collector assembly 150, motor requirements are minimal since this configuration has little torque in operation. In the disclosed embodiment, system 130 utilizes sensor 133 and associated control circuit to provide accurate control over the alignment of replaceable solar collector component 150 to the sun's position in the manner described below. Alternatively, the tracking system may be installed and calibrated so that a controller can orient the unit using an open loop circuit that utilizes the known solar parameters associated with each installation.

As mentioned above and as shown in Fig. 1(A), replaceable solar collector component 150 includes one or more solar energy collection elements 160 permanently or detachably secured to a support frame 170. According to an aspect of the present invention, each solar energy collection element 160 includes an optical assembly 161 arranged to focus solar radiation onto a focal line FL, and a linearly-arranged solar energy collector 165 (e.g. a linear string of photovoltaic cells (PVCs), thermoelectric cells, or a conduit containing a heat transfer fluid) that is fixedly maintained on focal line FL, for example, by way of supports 162. As indicated in Fig. 1(B), optical assembly 161 uses reflective optics (e.g., a mirror 163 arranged in an approximately cylindrical parabolic shape) to reflect and concentrate (focus) solar beams B onto focus line FL, where solar energy collection element 160 (e.g., a serially connected string of PV cells arranged face down) converts the radiation to usable energy (e.g., electricity). Frame 170 is preferably light weight and of sufficient stiffness to maintain solar energy collection elements 160 in the orientation described herein. Those skilled in the art will recognize optical assembly 161 as being implemented in the first embodiment as a trough reflector. Although the present invention is described herein with reference to reflective optics for concentrating the solar radiation onto solar energy collector 165, those skilled in the art will recognize that optical elements may be formed that utilize refractive optics to achieve the described linear concentration onto focal line FL.

Fig. 1(B) shows two-part solar energy collection system 100 after permanent positioning component 110 is secured to a substantially planar support surface S (e.g., a rooftop), and replaceable solar collector component 150 is operably secured onto rotating platform 125. According to another aspect of the present invention, permanent positioning component 110 is constructed such that when frame 121 is secured to support surface S, rotational axis Z is aligned substantially perpendicular to the plane defined by support surface S. In addition, support frame 170 and rotating platform 125 are constructed such that, when operably assembled as shown in Fig. 1(B), focal line FL and linearly-arranged solar energy collector 165 are maintained substantially parallel to support surface S. That is, rotating platform 125 and replaceable solar collector component 150 are collectively rotated around the rotational axis Z, both focal line FL and linearly-arranged solar energy collector 165 remain in a plane P that is substantially parallel to the planar support surface S.

In accordance with an embodiment of the present invention, rotational positioning system 130 detects the position of the sun relative to solar energy collection elements 160, and sends a control signal to motor 135, thereby causing rotating platform 125 to turn such that focal line FL, which is defined by optical element 161, is generally parallel to the solar beams B. Rotational positioning system 130 also includes sensor 133 that detects the sun's position, and a processor or other mechanism for calculating an optimal rotational angle θ around axis Z. Due to the precise, mathematical understanding of planetary and orbital mechanics, the tracking can be determined by strictly computational means once the system is adequately located. In one embodiment, a set of sensors including GPS and photo cells are used with a feedback system to correct any variations in the drive train. In other embodiments such a feedback system may not be necessary.

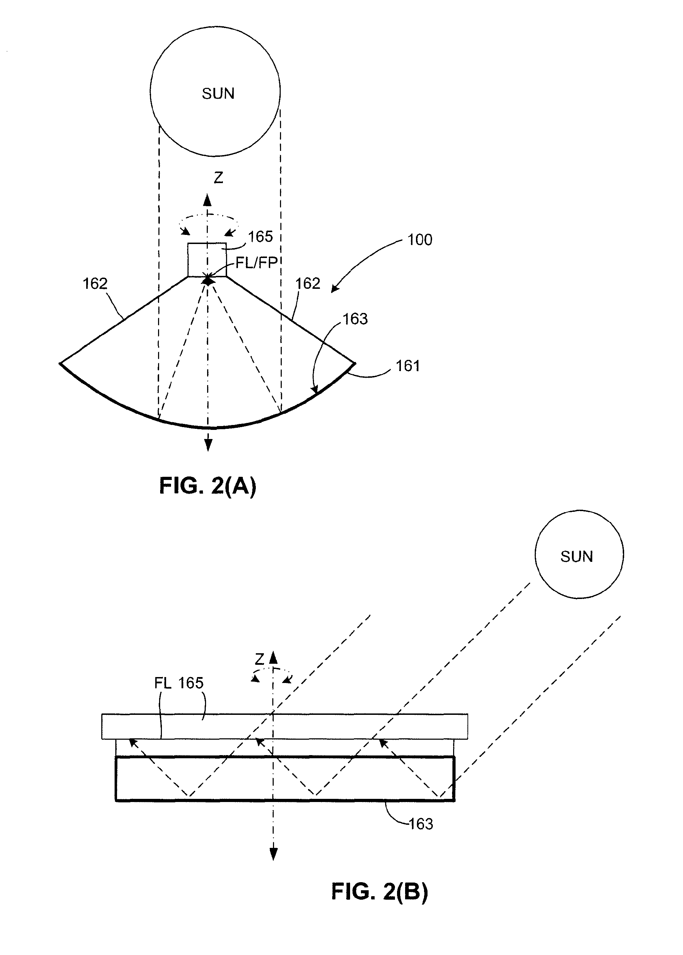

The operational idea is further illustrated with reference to Figs. 2 (A) and 2 (B) . Referring to Fig. 2(A), when focal line FL defined by optical element 161 is aligned generally parallel to the sun ray's that are projected onto device 100, the sun's ray will be reflected off the cylindrical parabolic mirror surface 163 and onto PV element 165 as a focused line (see Fig. 2(B)). The concept is similar to the textbook explanation of how parallel beams of light can be reflected and focused on to the focal point FP of a parabolic reflector, except that the parallel beams rise from below the page in Fig. 2(A), and the reflected rays emerge out of the page onto focal line FL (which is viewed as a point in Fig. 2(A), and is shown in Fig. 2(B)).

The concentration scheme depicted in Figs. 2(A) and 2(B) provides several advantages over conventional approaches. In comparison to convention cassegrain-type solar devices having high concentration ratios (e.g., 600X to 10,000X), the target ratio of 10X to 100X associated with the present invention reduces the engineering demands on reflector material, reflector geometry, and tracking accuracy. Conversely, in comparison to the high silicon costs of conventional flat panel solar arrays, achieving even a moderate concentration ratio (i.e., 25X) is adequate to bring the portion of cost of silicon photovoltaic material needed to produced PV element 165 to a small fraction of overall cost of replaceable solar collector component 150, which serves to greatly reduce the costs over conventional solar systems.

The side view shown in Fig. 2(B) further illustrates how sunlight directed parallel to focal line FL at a non-zero incident angle will still reflect off trough-like mirror 163 and will focus onto PV element 165. A similar manner of concentrating parallel beams of light can also be implemented by having the beams pass through a cylindrical lens, cylindrical Fresnel lens, or curved or bent cylindrical Fresnel lens but the location of the focal line will move toward the lens with increasing incidence angle of the sunlight due to the refractive properties of the lens and would degrade performance relative to a reflective system.

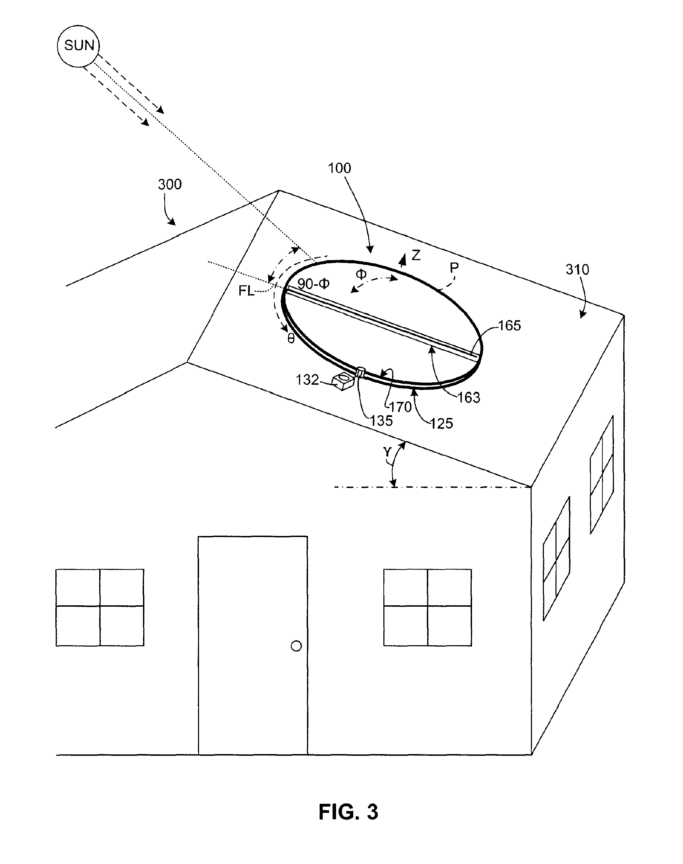

Fig. 3 is a perspective view depicting two-part solar energy collection system 100 disposed on the planar rooftop (support surface) 310 of a residential house 300 having an arbitrary pitch angle γ. In this embodiment, system 100 is mounted with rotating platform 125 secured to rooftop 310 by way of a support frame (not shown, discussed above), with support frame 170 disposed on rotating platform 125 such that axis Z is disposed substantially perpendicular to planar rooftop 310, whereby plane P defined by solar energy collector 165 (and focal line FL) remains parallel to the plane defined by rooftop 310 as trough reflector 101 rotates around said axis Z. As depicted in Fig. 3, a benefit of the present invention is that the substantially vertical rotational axis Z of device 100 allows tracking to take place in the plane of rooftop 310 of a residential house for most pitch angles γ. Further, because trough reflector 101 remains a fixed, short distance from rooftop 310, this arrangement minimizes the size and weight of the support structure needed to support and rotate system 100, thereby minimizing engineering demands on the foundation (i.e., avoiding significant retrofitting or other modification to rooftop 310), and allows tracking without increasing the wind load on the solar collector.

Mathematically, as indicated in Fig. 3, for every position of the sun there exists one angle θ (and 180°+θ) around which reflector trough 101 rotates, such that the sun's ray will all focus onto solar energy collector 165. Fig. 3 also illustrates that for any plane P there is a unique normal vector, and the incident angle of sunlight is measured off the normal as "Φ", and the two lines subtend an angle which is simply 90° - Φ. The projection line always exists, and so, no matter where and how mirror 163 is mounted, as long as solar energy collector 165 rotates in plane P around the normal vector (i.e., axis Z), trough reflector mirror 163 will eventually be positioned parallel to the projection line, and hence PV concentration will be carried out properly.

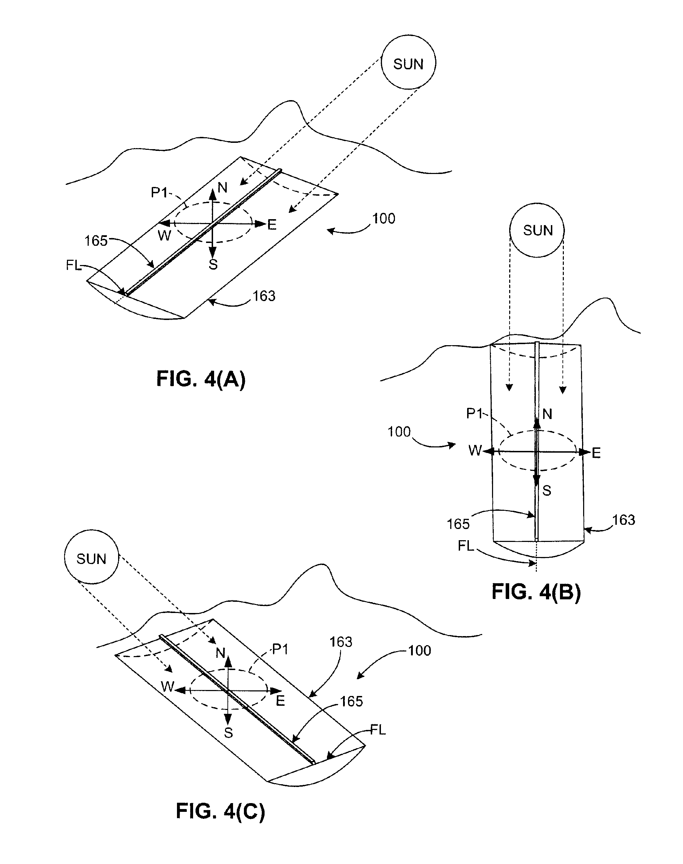

Figs. 4(A) to 4(C) are simplified perspective diagrams depicting system 100 in operation during the course of a typical day in accordance with an embodiment of the present invention. In particular, Figs. 4(A) to 4(C) illustrate the rotation of trough reflector mirror 163 such that solar energy collector 165 (and focal line FL) remains in plane P, and such that solar energy collector 165 (and focal line FL) is aligned parallel to the incident sunlight. As indicated by the superimposed compass points, this rotation process includes aligning mirror 163 in a generally east-west direction during a sunrise time period (depicted in Fig. 4(A)), aligning mirror 163 in a generally north-south direction during a midday time period (depicted in Fig. 4(B)), and aligning mirror 163 in a generally east-west direction during a sunset time period (depicted in Fig. 4(C)). This process clearly differs from conventional commercial trough arrays that rotate around a horizontal axis and remain aligned in a generally north-south direction throughout the day. The inventors note that some conventional commercial trough arrays are aligned in a generally east-west direction (as opposed to north-south, as is customary), and adjust the tilt angle of their trough reflectors south to north to account for the changing positions of the sun between summer to winter, i.e., instead of pivoting 180 degrees east to west from morning to evening. However, unlike the architecture in this invention, these east-west aligned trough arrays do not rotate their troughs around perpendicular axes. Also, in many part of the world the sun moves along an arc in the sky. Thus, even though the angular correction is small, over the course of a day the east-west aligned troughs still have to pivot along their focal line to keep the focused sunlight from drifting off.

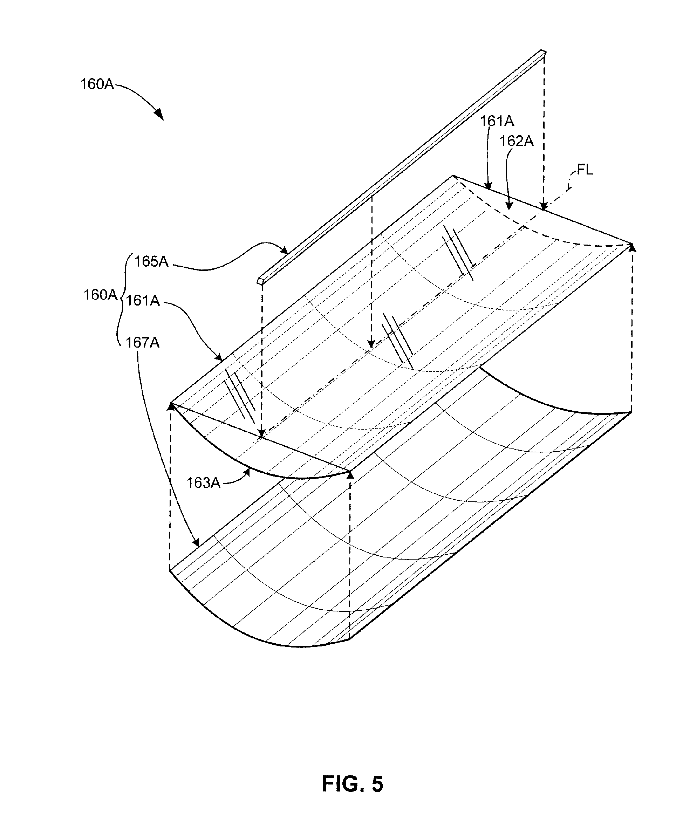

Fig. 5 is a simplified exploded perspective view showing a solar energy collection element 160A according to an alternative embodiment of the present invention. Similar to conventional trough-type solar collectors (e.g., such as those described above with reference to Figs. 15(A) to 15(C)), solar energy collection element 160A generally includes a trough reflector formed by a parabolic trough reflector mirror 167A shaped to reflect solar (light) beams onto a photovoltaic (PV) receiver (solar energy collection element) 165A that is disposed on a focal line FL of mirror 167A. However, solar energy collection element 160A differs from conventional trough-type solar collectors in that trough reflector mirror 167A is disposed on a solid optical element 161A upon which both PV receiver 165A and mirror 167A are fixedly connected. Solid transparent optical element 161A has a predominately flat upper aperture surface 162A and a convex (linear parabolic) lower surface 163A. PV receiver 165A is mounted on a central region of aperture surface 162A, and mirror 167A is conformally disposed on convex lower surface 163A.

Solid transparent optical element 161A includes an integrally molded, extruded or otherwise formed single-piece element made of a clear transparent optical material such as low lead glass, a clear polymeric material such as silicone, polyethylene, polycarbonate or acrylic, or another suitable transparent material having characteristics described herein with reference to optical element 161A. The cross-sectional shape of optical element 161A remains constant along its entire length, with upper aperture surface 162A being substantially flat (planar) in order to admit light with minimal reflection, and convex lower surface 163A being provided with a parabolic trough (linear parabolic) shape. In one specific embodiment, optical element 161A is molded using a low-iron glass (e.g., Optiwhite glass produced by Pilkington PLC, UK) structure according to known glass molding methods. Molded low-iron glass provides several advantages over other production methods and materials, such as superior transmittance and surface characteristics (molded glass can achieve near perfect shapes due to its high viscosity, which prevents the glass from filling imperfections in the mold surface). The advantages described herein may be also achieved by optical elements formed using other light-transmitting materials and other fabrication techniques. For example, clear plastic (polymer) may be machined and polished to form single-piece optical element 161A, or separate pieces by be glued or otherwise secured to form optical element 161A. In another embodiment, polymers are molded or extruded in ways known to those skilled in the art that reduce or eliminate the need for polishing while maintaining adequate mechanical tolerances, thereby providing high performance optical elements at a low production cost.

According to another aspect of the invention, mirror 167A is deposited on or otherwise conformally fixedly disposed onto convex lower surface 163A such that the reflective surface of mirror 167A faces into optical element 161A and focuses reflected sunlight onto a predetermined focal line FL. As used herein, the phrase "conformally fixedly disposed" is intended to mean that no air gap exists between mirror 167A and convex lower surface 163A. That is, the reflective surface of mirror 167A has substantially the same linear parabolic shape and position as that of convex lower surface 163A.

In one specific embodiment of the present invention, mirror 167A is fabricated by sputtering or otherwise depositing a reflective mirror material (e.g., silver (Ag) or aluminum (Al)) directly onto convex surface 163A, thereby minimizing manufacturing costs and providing superior optical characteristics. By sputtering or otherwise conformally disposing a mirror film on convex surface 163A using a known mirror fabrication technique, primary mirror 167A automatically takes the shape of convex surface 163A. As such, by molding, extruding or otherwise forming optical element 161A such that convex surface 163A is arranged and shaped to produce the desired mirror shape of mirror 167A, the fabrication of mirror 167A is effectively self-forming and self-aligned, thus eliminating expensive assembly and alignment costs associated with conventional trough reflectors. Further, by conformally disposing mirror 167A on convex lower surface 163A in this manner, the resulting linear parabolic shape and position of mirror 167A are automatically permanently set at the desired optimal optical position. That is, because primary mirror 167A remains affixed to optical element 161A after fabrication, the position of mirror 167A relative to aperture surface 162A is permanently set, thereby eliminating the need for adjustment or realignment that may be needed in conventional multiple-part arrangements. In another embodiment, mirror 167A includes a separately formed reflective, flexible (e.g., polymer) film that is adhesively or otherwise mounted (laminated) onto convex surface 167A. Similar to the directly formed mirror approach, the film is substantially self-aligned to the convex surface during the mounting process. This production method may decrease manufacturing costs over directly formed mirrors, but may produce slightly lower reflectivity.

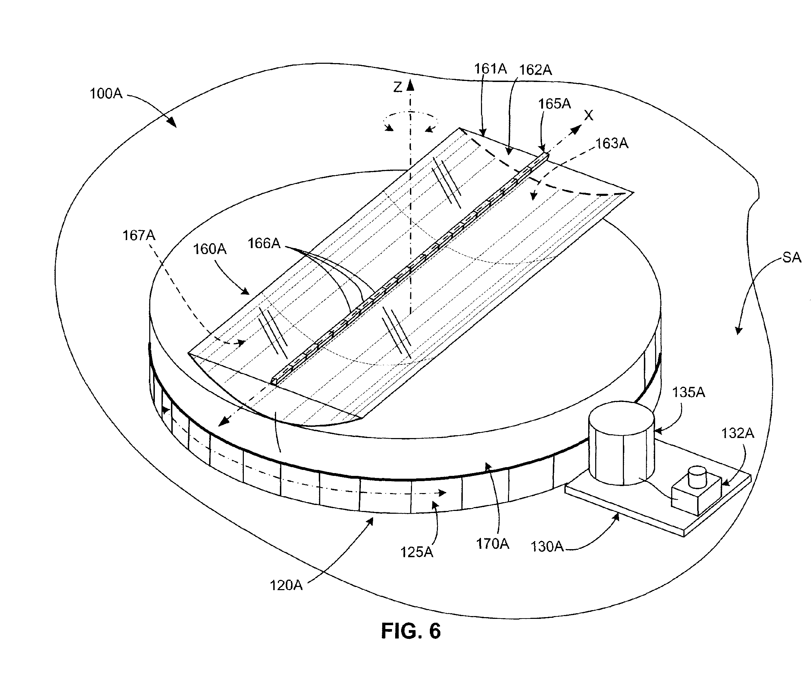

Fig. 6 is a perspective view showing a two-part solar energy collection system 100A according to an alternative embodiment of the present invention. Similar to system 100 (described above), system 100A includes a base structure 120A including a frame (not shown) and a rotating platform 125A rotatably disposed on the frame around a rotational axis Z, a rotational positioning system 130A including a tracking system 132A and a motor 135A for adjusting the rotational angle of rotating platform 125A, and a support frame 170A, that is removably secured to rotating platform 125A. System 100A differs from earlier embodiments in that it includes solar energy collection element 160A, which is described above with reference to Fig. 5 and secured to support frame 170A as shown in Fig. 6. When assembled, PV receiver 167A is fixedly disposed onto the central linear region of aperture surface 162A that coincides with focal line FL such that no air gap exists between PV receiver 167A and convex lower surface 163A, and such that an active (sunlight receiving) surface of PV receiver 167A faces into optical element 161A. With this arrangement, substantially all of the concentrated (focused) sunlight reflected by mirror 167A is directed onto the active surface of PV receiver 167A. PV receiver 167A traverses the length of solid optical element 161A, and is maintained in a fixed position relative to mirror 167A by its fixed connection to aperture surface 162A. In one embodiment, PV receiver 167A is an elongated structure formed by multiple pieces of semiconductor (e.g., silicon) connected end-to-end, where each piece (strip) of semiconductor is fabricated using known techniques in order to convert the incident sunlight to electricity. The multiple semiconductor pieces are coupled by way of wires or other conductors (not shown) to adjacent pieces in a series arrangement. Although not specific to the fundamental concept of the present invention, PV receiver 167A comprises the same silicon photovoltaic material commonly used to build conventional solar panels, but attempts to harness 10X or more of electricity from the same active area. Other PV materials that are made from thin film deposition can also be used. When high efficiency elements become economically viable, such as those made from multi-junction processes, they can also be used in the configuration described herein.

Solar energy collection system 100A operates substantially in the manner described above with reference to Figs. 1-4, but also benefits from the cost-saving advantages associated with utilizing solid transparent optical element 161A that are set forth above.

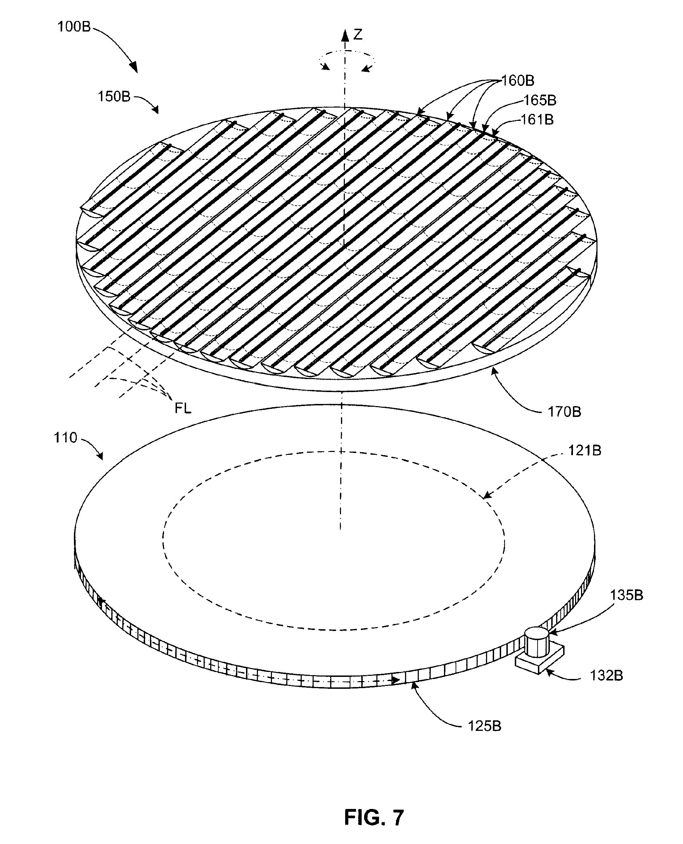

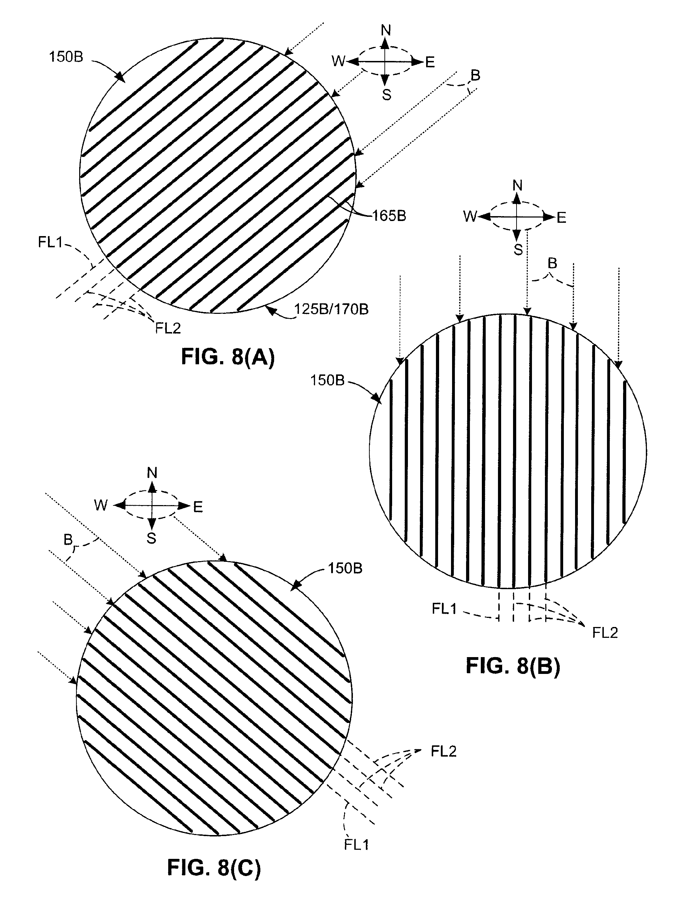

Fig. 7 is a top side perspective view showing a two-part solar energy collection system 100B according to another specific embodiment of the present invention. Similar to system 100A (described above), solar energy collection system 100B includes a permanent positioning component 110B including a tracking system 132B that utilizes a motor 135B engaged with a peripheral edge of a rotating platform 125B, which is rotatably supported on a stationary frame 121B as described above, to rotate platform 125B around an axis Z. However, system 100B differs from previous embodiments in that replaceable solar collector component 150B includes multiple solar energy collection elements 160B that are fixedly mounted on a support frame 170B. Similar to the previous embodiments, each solar energy collection element 160B includes an associated optical element 161B arranged to focus solar radiation onto an associated focal line FL, and an associated linearly-arranged solar energy collector 165B fixedly maintained on its associated focal line FL. In accordance with a specific embodiment, the associated optical element 161B of each solar energy collection element 160B is a single-piece, solid optical element similar to that described above with reference to Figs. 5 and 6. According to an aspect of this embodiment, solar energy collection elements 160B are arranged such that associated focal lines FL are parallel and define in a single plane that passes through solar energy collectors 165B. With this arrangement, and depicted in Figs. 8(A) to 8(C), when replaceable solar collector component 150B is rotated in a manner similar to the embodiments described above, but all focal lines FL1 and FL2 (and, hence, linear are aligned parallel to the projections of solar beams B onto the rotating disc. The weight of optical elements 161B is thus spread by circular positioning component 110B over a large area, further facilitating rooftop mounting. The low profile and in-plane rotation of the optical elements reduces the chance of wind and storm damage in comparison to conventional trough reflector arrangements.

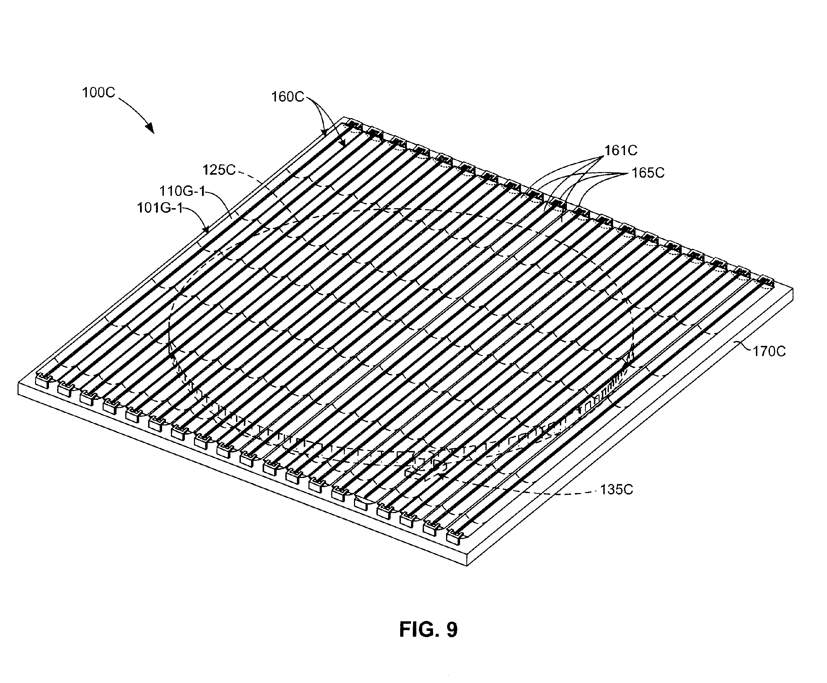

Fig. 9 is a top side perspective view showing a solar-electricity generation array 100C according to yet another specific embodiment of the present invention. Similar to system 100B (described above), two-part solar energy collection system 100C utilizes a positioning component having a circular rotating platform 125C and a peripherally positioned drive motor 135C, and includes a replaceable solar collector component 150C including multiple parallel solar energy collection elements (trough reflectors) 160C that are fixedly coupled to a base structure 170C such that rotation of rotating platform 125C causes rotation of all solar energy collection elements 160C in the manner described above. However, array 100C differs from device 100B in that all of elements 160C have a common (i.e., the same) length, and all elements 160C are mounted onto a square or rectangular support frame 170C, which is removably mounted over and rotated by rotating platform 125C. The term "common length" is used herein to indicate that the length of each solar energy collector (e.g., PV cell string) 165C disposed on the focal line of its corresponding optical element 161C is substantially equal. By providing each element 160C with a common length, the voltage generated from the string of PV cells disposed on each element 160C is approximately the same, thereby simplifying the electrical system associated with solar energy collection system 100C in some embodiments. In addition, providing each optical element 161C with the same length simplifies the production and assembly processes.

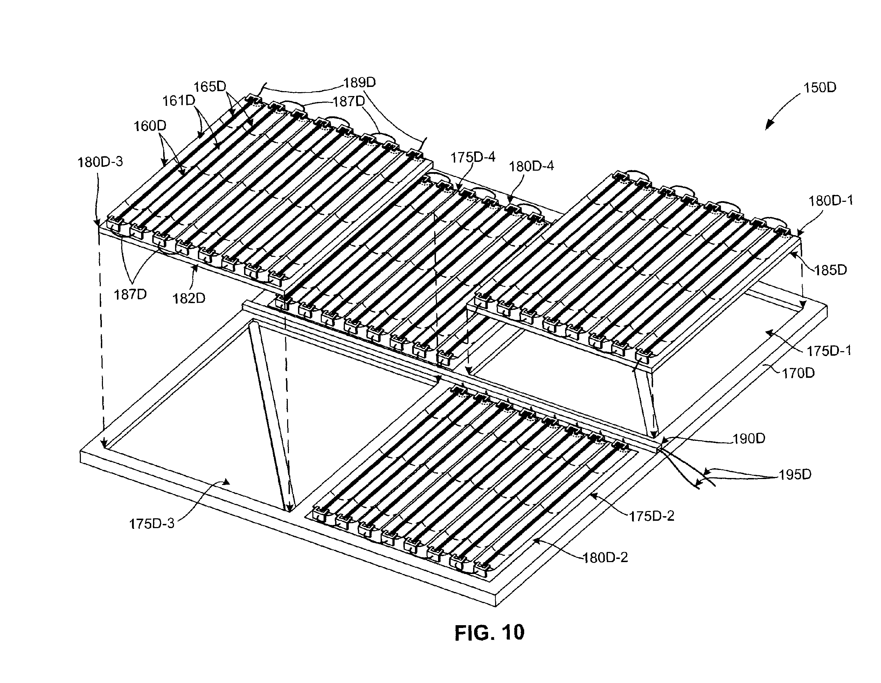

Fig. 10 is a top side exploded perspective view showing a replaceable solar collector component 150D according to yet another specific embodiment of the present invention. Similar to the replaceable component of system 100C (described above), replaceable solar collector component 150D includes a square or rectangular support frame 170D, and multiple common-length elements 160D. However, array 100D differs from device 100C in the manner set forth in the following paragraphs.

First, replaceable solar collector component 150D includes four sub-assembly units 180D-1 to 180D-4 that are separately mounted onto designated regions 175D-1 to 175D-4, respectively, of support frame 170D. For example, sub-assembly units 180D-1 and 180D-3 are mounted onto designated regions 175D-1 and 175D-3 as indicated by the dashed line arrows in Fig. 10. As indicated on sub-assembly unit 180D-3, each sub-assembly unit 180D-1 to 180D-4 includes a base structure 182D and a predetermined number of solar energy collection elements 160D that are fixedly attached to base structure 182D. The phrase "predetermined number" is used herein to designate that each sub-assembly unit 180D-1 to 180D-4 includes the same number (e.g., eight as shown in the exemplary embodiment) of solar energy collection elements 160D. Similar to solar energy collection elements 160C, solar energy collection elements 160D include an optical elements 161D having linear solar energy collectors (e.g., PV cell string) 165D disposed on parallel focal lines defined by corresponding optical elements 161D. In this case it may be justified to present a group of individual connections which are run to the inverter or load. By integrating a fixed, predetermined number of solar energy collection elements 160D on each sub-assembly unit 180D-1 to 180D-4, the sub-assembly units can be made a standard size (e.g., two foot square) while the assembled replaceable solar collector component 150D may be of indeterminate size (square or rectangular with dimensions in increments of approximately two feet, for example). This arrangement allows for fewer tracking motors, etc., while allowing for a smaller, stronger, and easy to manufacture replaceable optical assembly.

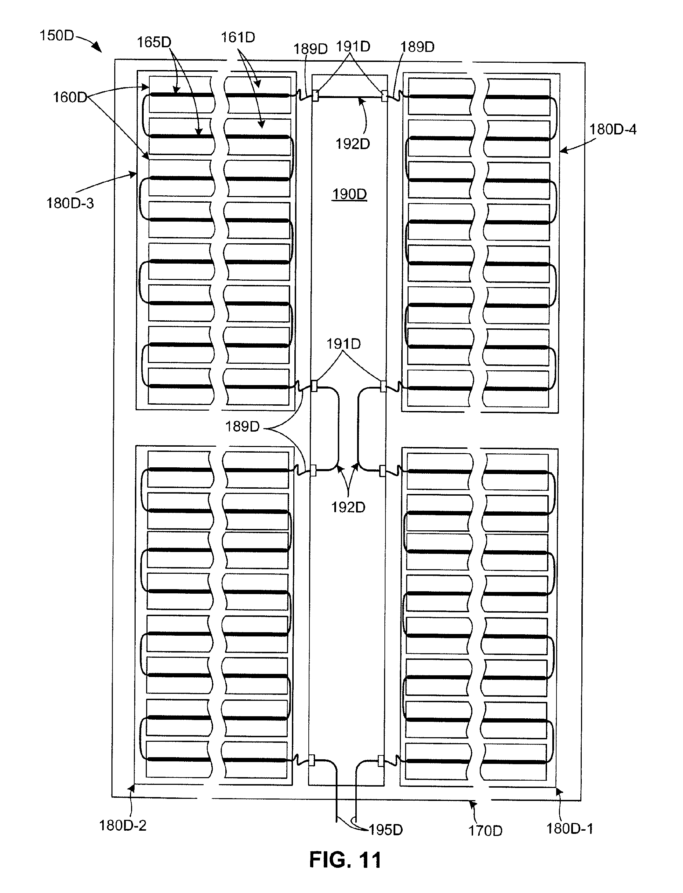

According to another aspect, sub-assembly units 180D-1 to 180D-4 are mounted on support frame 170D such that an end of each solar energy collection element 160D is disposed along a central linear region of the support frame 170D, and replaceable solar collector component 150D includes a central conduit 190A disposed on the central linear region that is electrically connected to the multiple solar energy collectors 165A of each sub-assembly units 180D-1 to 180D-4. As indicated in Fig. 10, sub-assembly units 180D-1 to 180D-4 are respectively mounted on frame 170D such that solar energy collection elements 160D extend perpendicular to central conduit 190A in order to minimize electrical connections. In one embodiment, solar energy collection elements 160D disposed on the side edges of each sub-assembly unit 180D-1 to 180D-4 include protruding wire conductors for electrical connection to central conduit 190A, and solar energy collection elements 160D disposed between these outside elements are connected in series by loop conductors. For example, referring to sub-assembly unit 180D-3, end wire conductors 189D extend from the opposing outside solar energy collection elements 160D for connection to central conduit 190A, and the remaining inside solar energy collection elements 160D are connected in series by interior wire conductors 187D. Thus, as further illustrated by the simplified wiring diagram shown in Fig. 11, the strings of PV cells making up each solar energy collection elements 160D of sub-assembly units 180D-1 to 180D-4 are wired so that the electrical connections are presented to central conduit 190D by way of sockets 191D, and central conduit 190D includes inside conductors 192D that connect the strings into a single serial circuit connected to external wires 195D, which are sued to conduct the electricity generated by the strings of PV cells to an inverter or other load. The inventors currently feel it is convenient to connect two or more PV strings in series so that both ends of the PV circuit are presented centrally to the array. The inventors also currently feel it is advantageous to keep the number of electrical connections between each sub-assembly unit 180D-1 to 180D-4 to central conduit 190D at a minimum. In that regard, it is advantageous to connect the strings of PV cells as indicated in Fig. 11. Those skilled in the art will recognize that this wiring arrangement may limit the performance of the sub-assembly unit array in certain situations due to irregular illumination and/or non-ideal or variable cell to cell performance, and therefore a wiring scheme may be utilized that utilizes a greater number of conductors to route the generated electricity from only one or a few PV strings to the inverter/load.

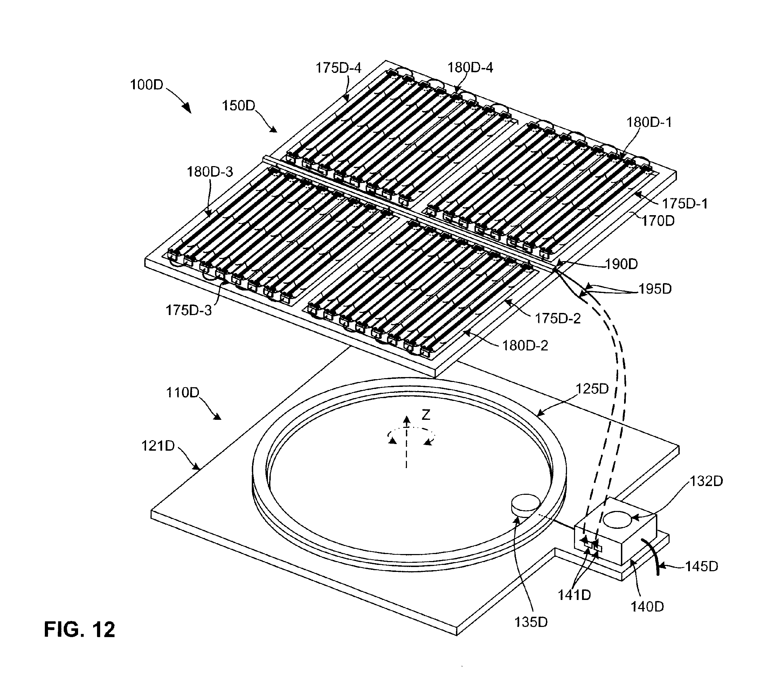

Fig. 12 is a top side perspective view showing a two-part solar energy collection system 100D according to another specific embodiment of the present invention. System 100D includes a permanent positioning component 110B including a tracking system 132D that utilizes a motor 135D engaged with an inner peripheral edge of a rotating platform 125D, which is rotatably supported on a stationary frame 121D as described above, to rotate platform 125D around an axis Z. System 100D also utilizes replaceable solar collector component 150D, which is described above and shown in a fully assembled state (i.e., with sub-assembly unit 180D-1 to 180D-4 fully inserted into regions 175D-1 to 175D-4 of frame 170D, and with the end wire conductors connected to corresponding sockets on central conduit 190D). According to an aspect of this embodiment, positioning system 110D also has a power transfer system 140D including one or more connector 141D (e.g., one or more sockets) and a robust cable 145D operably coupled to connectors 141D. When replaceable solar collector component 150D is operably installed on rotating platform 125D, external wires 195D are coupled to connectors 141D (i.e., as indicated by the dashed line arrows in Fig. 12), thereby facilitating the transfer of power from sub-assembly unit 180D-1 to 180D-4 to a designated load circuit (not shown).

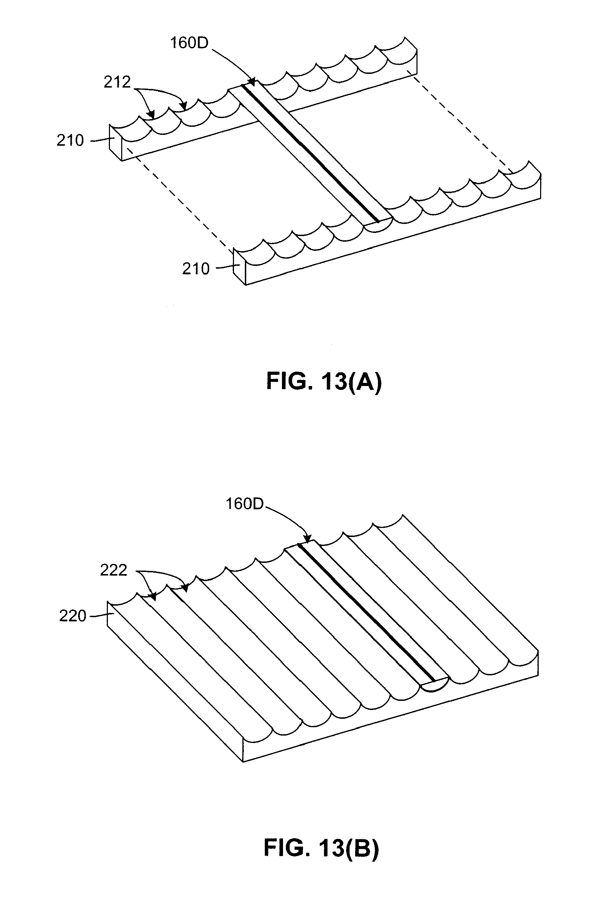

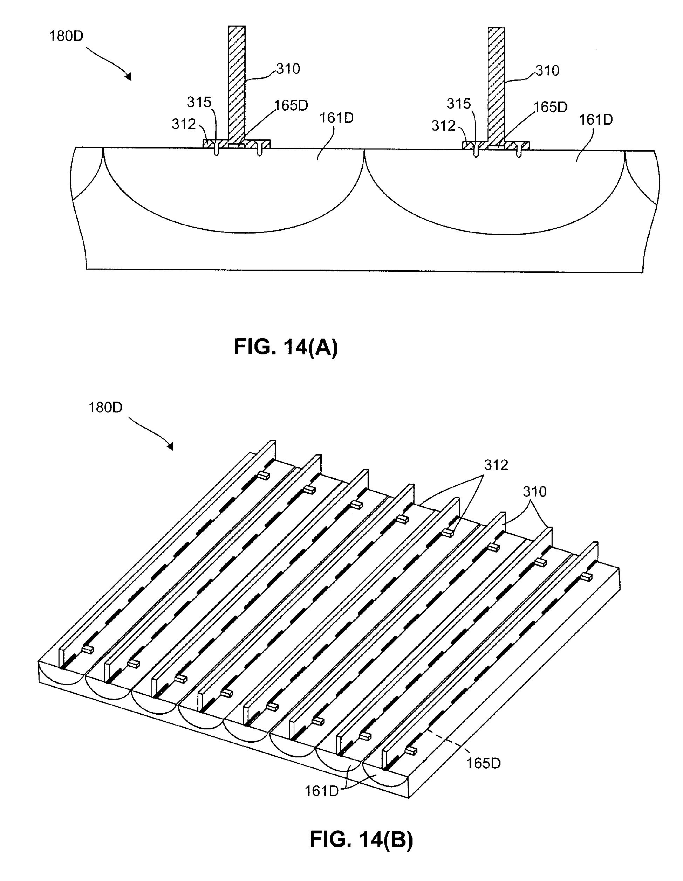

Replaceable sub-assembly unit 180D (described above with reference to Fig. 10) is preferably strong enough to be handled easily during assembly, transport, and installation. To that end, because replaceable sub-assembly unit 180D is made primarily of transparent solid material, sub-assembly unit 180D is either small enough to have sufficient integral strength, or is strengthened with supports on at least one of the back (lower) side and the front (upper) side. For example, Figs. 13(A) and 13(B) show alternative support members 210 and 220 having curved grooves 212 and 222 that are optionally used to support the curved back surface of solid optical elements 161D (i.e., each solid optical elements 161D rests in an associated groove 212 or 222 of support members 210 and 220), thereby serving to strengthen each sub-assembly unit 180D from the back (lower) side of optical elements 161D. Shadowing on the backside is not a concern and these members can be placed without regard to optical losses. In addition, Figs. 14(A) and 14(B) are partial end and perspective top views showing sub-assembly unit 180D with heat sink structures 310 disposed on the front (upper) side of each optical element 161D. As indicated, heat sink 310 is secured to the upper aperture surfaces of adjacent such that heat sinks 310 are disposed over and contact the back sides of PV strings (solar energy collectors) 165D. This is best accomplished by providing periodic points on the upper surfaces of transparent optical elements 161D where fasteners 315 are used to attach the heat sink assembly to the transparent solid by way of flanges 312, as shown in Fig. 14(A). Alternatively, or in addition, cross members with low cross section (and therefore limited shadowing) can be used to connect the heat sinks to one another, thereby strengthening the assembly. The mounting of the PV cell strings is therefore conveniently accomplished by attaching them to the heat sink (e.g. an aluminum or copper fin) using an elastomeric adhesive or other composite material which will both support the PV cells/string and allow for differences in thermal expansion of the various parts (cells, conductors, heat sink material). The PV cells are preferably high efficiency Si PV elements as are known in the industry.

Although the present invention is described above with specific reference to photovoltaic and solar thermal arrangements, other types of solar-energy collection elements may be utilized as well, such as a thermoelectric material (e.g., a thermocouple) that is disposed on the focal line of the trough arrangements described herein to receive concentrated sunlight, and to covert the resulting heat directly into electricity. In addition, optical elements like prisms and wedges that use reflection and/or total internal reflection to concentrate light into a linear or rectangular area can also be used instead of a trough reflector. In this case the photovoltaic cells are positioned off the long ends of the concentrating optical element where the light is being concentrated. Further, off-axis conic or aspheric reflector shapes may also be used to form a trough-like reflector. In this case the photovoltaic cells will still be positioned off the aligned parallel to the trough but will be positioned and tilted around the long axis of the trough.

## Claims

1. A permanent positioning component for a two-part solar energy collection system including both the permanent positioning component and a replaceable solar collector component that is removably connectable to the permanent positioning component, the replaceable solar collector component including one or more solar energy collection elements fixedly mounted on a support frame, wherein each of the one or more solar energy collection elements includes an optical element arranged to focus solar radiation onto a focal line, and a linearly-arranged solar energy collector fixedly maintained on the focal line, wherein the permanent positioning component comprises:
a base structure including a frame and a rotating platform rotatably disposed on the frame such that the rotating platform is rotatable around a rotational axis relative to the frame, and
a rotational positioning system including means for adjusting the rotational angle of the rotating platform around the rotational axis; and
wherein, when the frame of the base structure is operably secured to the planar support surface, the rotational axis is maintained substantially perpendicular to said support surface, and
wherein, when the support frame of the replaceable solar collector component is operably secured to the rotating platform, the focal line of the one or more solar energy collection elements is maintained in a plane that is substantially parallel to the planar support surface while the rotating platform and replaceable solar collector component are collectively rotated around the rotational axis.

2. The permanent positioning component according to claim 1, wherein rotational positioning system comprises a tracking system including means for detecting a position of the sun relative to the one or more solar energy collection elements, and means for rotating the rotating platform such that the focal line is parallel to solar beams generated by the sun that are directed onto the one or more solar energy collection elements.

3. The permanent positioning component according to claim 2, wherein said tracking system including means for controlling a rotational position of the one or more solar energy collection elements such that:
during a sunrise time period, the focal line is aligned in a first generally east-west direction,
during a midday time period, the focal line is aligned in a generally north-south direction, and
during a sunset time period, the focal line is aligned in a second generally east-west direction.

4. A replaceable solar collector component for a two-part solar energy collection system including both a permanent positioning component and the replaceable solar collector component, wherein the a permanent positioning component includes a base structure including a frame and a rotating platform rotatably disposed on the frame such that the rotating platform is rotatable around a rotational axis relative to the frame, and a rotational positioning system including means for adjusting the rotational angle of the rotating platform around the rotational axis, wherein the replaceable solar collector component comprises:
a support frame;
one or more solar energy collection elements fixedly mounted on the support frame, wherein each of the one or more solar energy collection elements includes an optical element arranged to focus solar radiation onto a focal line, and a linearly-arranged solar energy collector fixedly maintained on the focal line,
wherein, when the support frame of the replaceable solar collector component is operably secured to the rotating platform, the focal line of the one or more solar energy collection elements is maintained in a plane that is substantially parallel to the planar support surface while the rotating platform and replaceable solar collector component are collectively rotated around the rotational axis.

5. The solar collector component according to claim 4, wherein the optical element of the one or more solar energy collection elements utilizes one of reflective optics and refractive optics to concentrate solar radiation onto the focal line.

6. The solar collector component according to claim 4 or claim 5, wherein the optical element of the one or more solar energy collection elements comprises a trough reflector.

7. The solar collector component according to any of claims 4 to 6, wherein the optical element of the one or more solar energy collection elements comprises:
a single-piece, solid optical element having a predominately flat upper aperture surface and a convex lower surface disposed opposite to the upper aperture surface; and
a mirror that is conformally disposed on the convex lower surface, wherein the convex lower surface and mirror are arranged such that sunlight passing through the flat upper aperture surface is reflected and focused by the mirror onto said focal line,
wherein the linearly-arranged solar energy collector is fixedly disposed on the focal line to receive the focused light reflected by the mirror.

8. The solar collector component according to claim 7,
wherein the focal line substantially coincides with a linear section of the upper aperture surface, and
wherein the linearly-arranged solar energy collector comprises a serially-connected plurality of photovoltaic cells fixedly mounted on the linear section of the upper aperture surface.

9. The solar collector component according to any of claims 4 to 8,
wherein said replaceable solar collector component comprises a plurality of solar energy collection elements fixedly mounted on said support frame, wherein each of the plurality of solar energy collection elements includes an associated optical element arranged to focus solar radiation onto an associated focal line, and an associated linearly-arranged solar energy collector fixedly maintained on said associated focal line, and
wherein the associated linearly-arranged solar energy collectors of the plurality of solar energy collection elements are fixedly arranged on said support frame such that said associated focal lines are parallel and define a single plane.

10. The solar collector component according to claim 9, wherein said solid optical element of each of said plurality of solar energy collection elements has a common length.

11. The solar collector component according to claim 10, further comprising a plurality of sub-assembly units, each of the plurality of sub-assembly units including a base structure and a predetermined number of said plurality of said solar energy collection elements fixedly attached to said base structure, wherein said plurality of sub-assembly units are mounted on said support frame.

12. The solar collector component according to claim 11,
wherein said plurality of sub-assembly units are mounted on said support frame such that an end of each of the plurality of solar energy collection elements is disposed along a central linear region of the support frame,
wherein said replaceable solar collector component includes a conduit disposed on the central linear region of the support frame, wherein the conduit is electrically connected to the linearly-arranged solar energy collector of each of the plurality of solar energy collection elements.

13. The solar collector component according to claim 12, wherein the base structure of each of the plurality of sub-assembly units comprises a series of curved grooves, wherein each of the predetermined number of said plurality of said solar energy collection elements is received in one of said series of grooves.

14. The solar collector component according to claim 12 or claim 13, wherein each of the plurality of sub-assembly units further comprises an elongated heat sink connected to the optical element of each of the plurality of solar energy collection elements and disposed over the associated solar energy collectors of said each solar energy collection element.

15. A two-part solar energy collection system for installation on a planar support surface, the two-part solar energy collection system comprising:
a permanent positioning component according to any of claims 1 to 3; and:
a replaceable solar collector component according to any of claims 4 to 14,
wherein, when the frame of the base structure is operably secured to the planar support surface, the rotational axis is maintained substantially perpendicular to said support surface, and
wherein, when the support frame of the replaceable solar collector component is operably secured to the rotating platform, the focal line of the one or more solar energy collection elements is maintained in a plane that is substantially parallel to the planar support surface while the rotating platform and replaceable solar collector component are collectively rotated around the rotational axis.

16. The two-part solar energy collection system according to claim 15,
wherein the positioning system further comprises a power transfer system including a connector and a first cable coupled to the first connector for transferring power from the plurality of solar energy collectors to a designated load circuit, and
wherein the first and second wires are coupled to the connector.
